# EUROPÄISCHE PATENTSCHRIFT

(11) **EP 2 768 008 B1**
(45) Veröffentlichungstag und Bekanntmachung des Hinweises auf die Patenterteilung: **20.05.2020**
(21) Anmeldenummer: 14000510.9
(22) Anmeldetag: 13.02.2014
(51) Int. Cl.: H01J 25/34, H01J 23/34, H04B 7/185, H03F 3/58, H03F 3/55

(54) **Steuervorrichtung für ein Sendeverstärkerelement**
Control device for a transmission amplifier element
Dispositif de commande pour un élément amplificateur d'émission

(30) Priorität: 14.02.2013 DE 102013002477
(43) Veröffentlichungstag der Anmeldung: 20.08.2014
(73) Patentinhaber: Tesat-Spacecom GmbH & Co. KG, 71522 Backnang (DE)
(72) Erfinder: Reinwald, Gerhard, D-71546 Aspach (DE); Katz, Hanspeter, D-70374 Stuttgart (DE)
(74) Vertreter: LKGLOBAL Lorenz & Kopf PartG mbB Patentanwälte

(56) Entgegenhaltungen:
- EP-A2- 1 478 088
- US-A1- 2006 186 817
- US-A1- 2006 234 626

## Beschreibung

Die vorliegende Erfindung betrifft Kommunikationstechnologie. Insbesondere betrifft die vorliegende Erfindung Satellitenkommunikation unter Verwendung einer Wanderfeldröhre. Weiter insbesondere betrifft die vorliegende Erfindung eine Steuervorrichtung für eine Wanderfeldröhre, eine erdferne Plattform, insbesondere Satellit, aufweisend eine erfindungsgemäße Vorrichtung, sowie ein Verfahren zum Einstellen eines Arbeitspunktes einer Wanderfeldröhre.

Eine Wanderfeldröhre, auch Travelling Wave Tube (TWT) genannt, ist eine hochspezialisierte Vakuumröhre, die zur Verstärkung von RF-Signalen Verwendung findet. Besonders bevorzugt werden Wanderfeldröhren auf erdfernen Plattformen wie beispielsweise Satelliten verwendet, um RF-Signale für die Kommunikation mit einem Kommunikationspartner, beispielsweise einer erdnahe bzw. Bodenstation, bereitzustellen.

Wanderfeldröhren realisieren dabei die Verstärkung des RF-Signals, indem freie Elektronen, welche sich in der Röhre von einer Kathode in Richtung einer Anode bewegen und im Weiteren von Kollektoren aufgefangen werden, einen Teil ihrer Bewegungsenergie an ein elektrisches, zu verstärkendes Signal abgeben. Wanderfeldröhren haben dabei bevorzugt ihren Einsatzbereich in einem Frequenzbereich 0,3 bis 50 GHz, wobei eine Verstärkung meist im Bereich von 30-60 dB realisierbar ist. Aufgrund ihres hohen Wirkungsgrades von bis zu 70% sind Wanderfeldröhren insbesondere oberhalb von 10 GHz Halbleiterverstärkern überlegen.

Für den Betrieb benötigen Wanderfeldröhren eine Heizspannung für die Glühkathode von einigen V zur Erzeugung des Elektronenstrahls, wobei die Elektronen nachfolgend in Richtung einer Anode beschleunigt und letztendlich nach Passage eines Bereichs mit einer Helixwindung durch einen Kollektor aufgenommen werden. Die Wanderfeldröhre ermöglicht dabei eine Energierückgewinnung durch die rückgewonnen Elektronen, woraus sich ihr vergleichsweise hoher Wirkungsgrad ergibt.

Im Weiteren wird ein axiales, durch Permanent- oder Elektromagnete erzeugtes Magnetfeld sowie eine Betriebsspannung bzw. Beschleunigungsspannung im kV-Bereich benötigt. Weitere benötigte Betriebsgrößen bzw. Betriebsenergiegrößen mögen beispielsweise Steuer- bzw. Fokussierspannungen für die Elektronenkanone sein. Weiterhin mag eine Kühlung des Kollektors und oft auch der Helix benötigt werden, insbesondere bei Hochleistungsanwendungen. Speziell in der Satellitentechnik wird eine elektrische Versorgungseinheit als Electronic Power Conditioner (EPC) bezeichnet. Eine Einheit aus TWT und EPC wird als Wanderfeldröhrenverstärker (Traveling Wave Tube Amplifier, TWT) bezeichnet.

Wanderfeldröhrenverstärker werden vornehmlich in Satelliten als Leistungsverstärker eingesetzt. Die Wanderfeldröhre bestimmt dabei hauptsächlich die Hochfrequenzeigenschaften. Im Weiteren ist eine Stromversorgung bzw. eine Steuervorrichtung für eine Wanderfeldröhre vorgesehen, die die Versorgungsspannungen für die Wanderfeldröhre erzeugt und im Weiteren eine Telemetrie bzw. Telekommandoschnittstelle zum Satelliten darstellt. Ergänzt werden kann ein Leistungsverstärker durch einen Vorverstärker, auch Kanalverstärker (CAMP) genannt, der auch einen Linearisierer (LCAMP) beinhalten kann. In einer derartigen Kombination wird eine solche Vorrichtung als ein Hochfrequenz-Leistungsmodul (Microwave Power Module, MPM) bezeichnet.

Die Hochfrequenzeigenschaften der Wanderfeldröhre werden neben dem Hochfrequenzdesign der Wanderfeldröhre selbst vorwiegend durch die Versorgungsspannungen bestimmt. Diese werden dabei derart eingestellt, dass die geforderten Leistungsmerkmale über einen geforderten Frequenzbereich eingehalten werden können. Insbesondere bei großen Frequenzbereichen muss ein Kompromiss zwischen Frequenzbereich und Anforderungen gefunden werden.

Allgemein erfolgt eine Einstellung einer Wanderfeldröhre derart, dass die Mitte des realisierten Frequenzbereiches so eingestellt wird, dass auch am Rande und damit im gesamten geforderten Frequenzbereich, die gestellten Anforderungen eingehalten werden. Im mittleren Bereich werden diese Anforderungen dabei meist weit übertroffen.

Bei sehr breitbandigen Anwendungen mag es auch vorkommen, dass überhaupt kein Betriebsarbeitspunkt gefunden werden kann, der den gesamten Frequenzbereich abzudecken vermag. In diesem Fall müssen Teilbereiche durch verschiedene Verstärker abgedeckt werden.

Der Vorverstärker eines MPMs muss dabei auf die Röhreneigenschaften abgeglichen werden, das heißt, wenn sich die Charakteristik der Röhre ändert, muss die Einstellung des Vorverstärkers entsprechend angepasst werden.

US 2006/234626 A1 und EP 1 478 088 A2 beschreiben Verstärkersysteme, welche die Ausgangsleistung von Hochleistungsverstärkerschaltungen mit einer Hochleistungsverstärkerschaltung von extern durchführen kann.

Ein Aspekt der vorliegenden Erfindung ist nun die Einstellung einer Steuervorrichtung einer erdfernen Plattform für ein RF-Sendeverstärkerelement, insbesondere einer zugehörigen Energieversorgungseinheit und/oder eines zugehörigen Vorverstärkers bzw. Kanalverstärkers und/oder Linearisierers in einer derart flexiblen Weise, so dass im Orbit, bei einer Satellitenapplikation, per Telekommando verschiedene Einstellungen ausgewählt werden können, je nachdem, in welchem Frequenzbereich bzw. Frequenzband der Verstärker bzw. das RF-Sendeverstärkerelement betrieben werden soll.

Demgemäß wird eine Steuervorrichtung für eine erdferne Plattform, eine erdferne Plattform, insbesondere ein Satellit, aufweisend eine erfindungsgemäße Vorrichtung, sowie ein Verfahren zum Einstellen eines Arbeitspunktes eines RF-Sendeverstärkerelementes auf einer erdfernen Plattform gemäß den unabhängigen Ansprüchen bereitgestellt. Bevorzugte Ausgestaltungen ergeben sich aus den abhängigen Ansprüchen.

Gemäß einer ersten Ausgestaltung der vorliegenden Erfindung wird eine Steuervorrichtung für eine erdferne Plattform angezeigt, aufweisend eine Steuereinheit mit zumindest einem Steuereingang und einem Steuerausgang und ein Speicherelement, wobei das Speicherelement eingerichtet ist, eine Mehrzahl von Betriebsgrößen-Parameter-Sets für zumindest ein RF-Sendeverstärkerelement vorzuhalten, wobei der Steuereingang eingerichtet ist zum Empfang eines Steuersignals, wobei die Steuereinheit eingerichtet ist, basierend auf dem Steuersignal ein Betriebsgrößen-Parameter-Set aus dem Speicherelement auszuwählen und wobei der Steuerausgang eingerichtet unter Verwendung des ausgewählten Betriebsgrößen-Parameter-Sets eine Energieversorgungseinheit und/oder ein Linearisierungselement derart zu beeinflussen, so dass das RF-Sendeverstärkerelement in einem bestimmten Arbeitspunkt betreibbar ist. Das Steuersignal beinhaltet die Information, auf welcher Frequenz bzw. in welchem Frequenzband das RF-Senderverstärkerelement betrieben werden soll.

Gemäß einer weiteren Ausgestaltung der vorliegenden Erfindung wird eine erdferne Plattform, insbesondere ein Satellit, aufweisend eine Steuervorrichtung der oben erwähnten Art, angezeigt.

Gemäß einer weiteren Ausgestaltung der vorliegenden Erfindung wird ein Verfahren zum Einstellen eines Arbeitspunktes eines RF-Sendeverstärkerelements, insbesondere auf einer erdfernen Plattform, angezeigt, aufweisend die Schritte Erhalten eines Steuersignals; Auswahl eines Betriebsenergiegrößen-Parameter-Sets aus einer Mehrzahl von Betriebsenergiegrößen-Parameter-Sets, welche lokal in einem Speicherelement vorgehalten werden; und Einstellen des Arbeitspunktes der Wanderfeldröhre, basierend auf dem ausgewählten Betriebsenergiegrößen-Parameter-Set. Das Steuersignal beinhaltet die Information, auf welcher Frequenz bzw. in welchem Frequenzband das RF-Senderverstärkerelement betrieben werden soll.

Im Weiteren wird die vorliegende Erfindung unter Bezugnahme auf eine Wanderfeldröhre als RF-Sendeverstärkerelement beschrieben. Diese Ausführungen greifen jedoch für ein beliebiges RF-Sendeverstärkerelement, insbesondere auch für einen Halbleiterverstärker. Wenn im Weiteren ein Betriebsenergiegrößen-Set bzw. Betriebsenergiegrößen-Parameter-Set beschrieben bzw. verwendet wird, so ist hierunter allgemein ein Betriebsgrößen-Set bzw. Betriebsgrößen-Parameter-Set zu verstehen.

Erfindungsgemäß wird eine Steuervorrichtung für eine Wanderfeldröhre, somit ein Electronic Power Conditioner, zur Ansteuerung und zum Betrieb einer Wanderfeldröhre bereitgestellt. Diese kann, muss aber nicht, einen Kanalverstärker und/oder einen Linearisierer aufweisen und somit im Wesentlichen ein Microwave Power Module darstellen.

Exemplarisch, im Falle einer Satellitenapplikation, erhält die Steuervorrichtung zum Beispiel von einer Bodenstation ein Kommando bezüglich eines gewünschten Betriebsmodus der Wanderfeldröhre. Neben möglichen weiteren Informationen kann dies dabei gemäß vorliegender Erfindung die Information beinhalten, auf welcher Frequenz bzw. in welchem Frequenzband die Wanderfeldröhre bzw. der Wanderfeldröhrenverstärker betrieben werden soll.

Hierbei ist vorteilhaft, dass keine komplexe Information übertragen wird, die detaillierte Informationen bzw. Parameter bezüglich der Einstellung eines Energieversorgungsmoduls beinhaltet. Vielmehr wird lediglich die Information übertragen, welches Frequenzband nun für die Übertragung verwendet werden soll. Sämtliche Parameter, die zur Einstellung und zum Betrieb der Steuervorrichtung und damit der Wanderfeldröhre benötigt werden, liegen dabei in einem Speicherelement in der Steuervorrichtung vor. Diese Informationen bzw. Parameter können beispielsweise von einem Hersteller des Satelliten bzw. zumindest des Wanderfeldröhrenverstärkers vorab bereitgestellt worden sein, so dass sichergestellt ist, dass die Wanderfeldröhre bestmöglich die geforderten Übertragungseigenschaften umsetzt. Eine entsprechende Vielzahl von Parameter-Sets können z.B. bei einem Testbetrieb während der Herstellung ermittelt und im Speicher abgelegt worden sein.

Als Telekommando wird somit im Wesentlichen nur eine Information übermittelt, dass der Wanderfeldröhrenverstärker (nun) in einem bestimmten Frequenzband arbeiten soll. Möglicherweise mag im Weiteren ebenfalls eine Information übermittelt werden, welches Modulationsverfahren für die Datenübertragung dabei verwendet wird. Diese beiden Informationen, die mit vergleichsweise geringem Datenaufwand an eine erdferne Plattform übertragen werden können, mögen dabei insbesondere auf umfangreiche Parameterdaten im Speicherelement zurückgreifen, um den Wanderfeldröhrenverstärker bestmöglich zu betreiben bzw. parametrisieren, jeweils unter Berücksichtigung der geforderten Übertragung.

Durch die Übertragung einer reinen Information, welches Übertragungsparameter-Set nun aus dem Speicherelement verwendet werden soll, und nicht etwa (komplexer) Steuerdaten bzw. Parameter selbst, die unmittelbar die Parametrisierung eines EPC vornehmen, wird ebenfalls sichergestellt, dass der Wanderfeldröhrenverstärker ausschließlich mit einem vollständigen und korrekten Parameter-Set betrieben wird, das auch gewünscht, gefordert und insbesondere getestet wurde.

Werden beispielsweise die Parameter selbst per Telekommando von einer Erdstation zu einem Satelliten übertragen und kommt es dabei zu einem Übertragungsfehler, so mag es passieren, dass alle oder einige Parameter nicht korrekt eingestellt werden, möglicherweise nicht zu anderen Parametern passen und damit eine Übertragung aufgrund einer falschen Einstellung der Wanderfeldröhre nicht mehr möglich ist. Schlimmstenfalls kommt es dabei zu einer Beschädigung des Wanderfeldröhrenverstärkers oder der Wanderfeldröhre, was im Falle eines katastrophalen Defektes letztendlich den Totalausfall des Verstärkers nach sich ziehen könnte.

Dies wird durch die Übertragung von einfachen Anweisungen per Telekommando, welcher Übertragungsmodus ausgewählt werden soll, mit nachfolgender Auswahl dieses Modus aus einem Speicherelement und Einstellen sämtlicher relevanter Parameter, basierend auf diesem ausgelesenen Speicherelement, wirksam vermieden. Zwar könnte aufgrund eines möglichen Datenübertragungsfehlers beim Übermitteln des Telekommandos ein nicht gewünschter Modus eingestellt werden, dieser würde dann jedoch trotzdem alle korrekten Parameter für diesen Modus berücksichtigen, so dass zumindest eine katastrophale Beschädigung von Elementen des Satelliten wirksam vermieden wird.

Somit lässt sich feststellen, dass der Wanderfeldröhrenverstärker durch die Auswahl eines Parameter-Sets aus dem Speicherelement in einem optimalen Arbeitspunkt betrieben werden kann. Dies resultiert zum Beispiel in einem besseren Wirkungsgrad und somit einer besseren Ausnutzung vorhandener Leistung. Im Falle eines Satelliten mag es dadurch möglich sein, diesen kostengünstiger aufzubauen.

Das Vorhalten einer Mehrzahl von Parameter-Sets erlaubt die Einstellung von einer Mehrzahl von Frequenzbereichen mit einem Gerät, wofür ohne Einstellbarkeit zwei oder sogar mehr Vorrichtungen benötigt werden würden. Somit mögen die Anzahl von im Satelliten vorgehaltenen Vorrichtungen reduziert und/oder insbesondere einfachere Redundanzkonzepte realisiert werden.

Werden beispielsweise mehrere TWTA/MPM in einem Satelliten vorgesehen, so kann jeder TWTA/MPM den gesamten Frequenzbereich abdecken. Daher kann jeder TWTA/MPM an jeder Frequenz des Redundanzkonzepts betrieben werden, was das Redundanzkonzept u. U. vereinfacht..

Erfindungsgemäß ist satellitenseitig somit eine Steuereinheit vorgesehen, welche, basierend auf einem Telekommando, aus dem Speicherelement ein gewünschtes bzw. gefordertes Betriebsenergiegrößen-Parameter-Set aus einer Mehrzahl von Betriebsenergiegrößen-Parameter-Sets auswählt. Ein solches Betriebsenergiegrößen-Parameter-Set definiert dabei sämtliche Betriebsgrößen, insbesondere bezüglich der Stromversorgung und Spannungsansteuerung einer Wanderfeldröhre, die benötigt werden, um die Wanderfeldröhre in einem bestimmten Betriebsmodus bzw. Arbeitspunkt, somit in einem bestimmten Betriebsfrequenzband zu betreiben.

Das Betriebsenergiegrößen-Parameter-Set ist somit als eine Information anzusehen, wie die eigentlichen Betriebsenergiegrößen, die an eine Wanderfeldröhre weitergegeben bzw. angelegt werden, eingerichtet sein sollen. Eine Energieversorgungseinheit der Steuervorrichtung kann damit von der Steuerung derart angesteuert werden, basierend auf den Informationen des Betriebsenergiegrößen-Parameter-Sets, ein Energiegrößen-Set bereitzustellen und dieses an die Wanderfeldröhre weiterzugeben bzw. an diese anzulegen.

Als Beispiel mag das Betriebsenergiegrößen-Parameter-Set eine Information enthalten, welche Anodenspannung bzw. Kathodenstrom für einen bestimmten Arbeitspunkt der Wanderfeldröhre einzustellen ist. Diese Information bezüglich der Anodenspannung wird unter Verwendung der Energieversorgungseinheit umgesetzt, so dass die tatsächliche, zu dieser Information bezüglich der Anodenspannung bzw. Kathodenstroms zugehörige reale Anodenspannung bzw. Kathodenstrom, erzeugt und der Wanderfeldröhre bereitgestellt bzw. an diese angelegt wird.

Gemäß einer bevorzugten Ausgestaltung der vorliegenden Erfindung ist der Steuereingang der Steuereinheit eingerichtet zum Empfang eines Steuersignals zur Auswahl eines bestimmten Arbeitspunktes bzw. eines bestimmten Betriebsenergiegrößen-Parameter-Sets, wobei die Steuereinheit, basierend auf dem Steuersignal, ein Betriebsenergiegrößen-Parameter-Set aus dem Speicherelement auswählt und wobei der Steuerausgang eingerichtet ist, unter Verwendung des ausgewählten Betriebsenergiegrößen-Parameter-Sets die Energieversorgungseinheit derart zu beeinflussen, das assoziierte Betriebsenergiegrößen-Set einzustellen bzw. auszugeben.

Gemäß einer weiteren bevorzugten Ausgestaltung der vorliegenden Erfindung kann die Wanderfeldröhre durch Einstellen bzw. Ausgeben der Energieversorgungseinheit mittels des Betriebsenergiegrößen-Sets an die Wanderfeldröhre einen bestimmten Arbeitspunkt einnehmen.

Die Steuervorrichtung ist somit eingerichtet, aus einer Mehrzahl von Betriebsenergiegrößen-Parameter-Sets das ausgewählte derart umzusetzen, so dass die zu diesem Betriebsenergiegrößen-Parameter-Set zugehörigen Betriebsenergiegrößen an die Wanderfeldröhre weitergegeben bzw. dort angelegt werden, um somit einen definierten bzw. gewünschten Arbeitspunkt der Wanderfeldröhre einzustellen.

Gemäß einer weiteren bevorzugten Ausgestaltung der vorliegenden Erfindung mögen die Betriebsenergiegrößen bzw. die Betriebsgrößen ausgebildet sein als Größen aus der Gruppe bestehend aus Strömen bzw. Spannungen, die an ein RF-Sendeverstärkerelement (4) anlegbar bzw. weitergebbar sind, eine Helix-Spannung, eine Kollektor-Spannung, ein Kathodenstrom, eine Anoden-0-Spannung, eine Anoden-1-Spannung, eine Heizerspannung, eine Wehneltspannung, eine Amplitudenexpansion, eine Phasendrehung, ein Frequenzgang und eine Verstärkung.

Zum Betrieb der Wanderfeldröhre ist bauartbedingt eine Mehrzahl von Strömen bzw. Spannungen notwendig. Diese Mehrzahl bzw. die Gesamtheit aller für den Betrieb der Wanderfeldröhre benötigten Spannungen und/oder Ströme und gegebenenfalls weiterer Parameter, z.B. bzgl. einer Signalvorverarbeitung, stellen dabei die Betriebsenergiegrößen dar, welche für einen gewünschten Arbeitspunkt als ein Betriebsenergiegrößen-Set darstellbar sind. Allgemein sind die Betriebsenergiegrößen dabei Betriebsgrößen. Ein Linearisierungselement (LIN) kann seine Vorverarbeitung bzw. seine Übertragungscharakteristik basierend auf dem Arbeitspunkt anpassen und dabei insbesondere eine Amplitudenexpansion, eine Phasendrehung, ein Frequenzgang und eine Verstärkung anpassen. Dies gilt auch, wenn das Linearisierungselement mit einem Kanalverstärker kombiniert ist (LCAMP), oder der Vorverstärker ein reiner Kanalverstärker (CAMP) ist, also keinen Linearisierer enthält. In diesem Fall mag insbesondere nur die Verstärkung und der Frequenzgang eines HF-Signals angepasst.

Gemäß der vorliegenden Erfindung beeinflusst bzw. bestimmt ein Arbeitspunkt der Wanderfeldröhre zumindest den Frequenzarbeitsbereich der Wanderfeldröhre, somit ein Frequenzband.

Gemäß einer bevorzugten Ausgestaltung der vorliegenden Erfindung mag die Steuervorrichtung mit einem Vorverstärker kombiniert sein, der u. a. Verstärkerstufen und ein Linearisierungselement aufweist, mit einem Hochfrequenzeingang und einem Hochfrequenzausgang, an welchem eine Wanderfeldröhre anschließbar ist. Das Linearisierungselement mag dabei eingerichtet sein, ein Hochfrequenzsignal über den Hochfrequenzeingang aufzunehmen und unter Berücksichtigung eines gewünschten bzw. geforderten Arbeitspunktes der Wanderfeldröhre vorzuverarbeiten. Die Vorverarbeitung mag dabei insbesondere eine Übertragungscharakteristik des Linearisierungselementes betreffen und dieses beeinflussen, basierend auf einem bestimmten bzw. gewünschten Arbeitspunkt. Insbesondere mag das Betriebsenergiegrößen-Parameter-Set weiterhin eine Information bzw. einen Parameter zur Einstellung des Linearisierungselementes aufweisen, um dieses in seiner Vorverarbeitung des Hochfrequenzsignals bzw. seiner Übertragungscharakteristik auf einen bestimmten bzw. geforderten Arbeitspunkt der Wanderfeldröhre anzupassen.

Somit mag das Speicherelement für ein bestimmtes Betriebsenergiegrößen-Parameter-Set auch eine Information enthalten, wie ein Kanalverstärker und/oder Linearisierer einzustellen ist, unter Berücksichtigung des gewünschten bzw. geforderten Arbeitspunktes, somit insbesondere des Frequenzbandes der Wanderfeldröhre.

Gemäß einer weiteren bevorzugten Ausgestaltung der vorliegenden Erfindung mag mittels der Mehrzahl von Betriebsenergiegrößen-Parameter-Sets ein Übertragungskanal auf ein gefordertes Modulationsverfahren für die Datenübertragung anpassbar sein.

In anderen Worten mögen für unterschiedliche Modulationsverfahren, selbst bei gleichem Frequenzband, unterschiedliche Betriebsenergiegrößen benötigt werden, um die Wanderfeldröhre besonders bevorzugt auf ein Modulationsverfahren anzupassen. Somit mag ein Betriebsenergiegrößen-Parameter-Set nicht nur einen Arbeitspunkt in Bezug auf ein Frequenzband einstellen, sondern im Weiteren die Wanderfeldröhre auch auf ein bestimmtes Modulationsverfahren anpassen bzw. optimieren.

Gemäß einer weiteren bevorzugten Ausgestaltung der vorliegenden Erfindung mag das Speicherelement in der Steuereinheit, in der Energieversorgungseinheit oder in dem Vorverstärker/Linearisierer angeordnet sein oder als verteiltes Speicherelement ausgebildet und in einer Mehrzahl von Steuereinheit, Energieversorgungseinheit und Vorverstärker/Linearisierungselement angeordnet sein.

Somit mag die Steuervorrichtung als Kombination einer Steuereinheit mit einer Energieversorgungseinheit als EPC ausgebildet sein, auch in Kombination mit einem Kanalverstärker/Linearisierungselement und als Kanalverstärker/Linearisierungselement ohne RF-Sendeverstärkerelement als reiner Vorverstärker und mit einem RF-Sendeverstärkerelement, insbesondere einer Wanderfeldröhre, als TWTA bzw. MPM ausgebildet sein.

Gemäß einer weiteren bevorzugten Ausgestaltung der vorliegenden Erfindung mag die Vorrichtung zumindest zwei RF-Sendeverstärkerelemente, zumindest zwei Linearisierungselemente und zumindest eine Energieversorgungseinheit aufweisen, wobei ein RF-Sendeverstärkerelement jeweils einem Linearisierungselement zugeordnet ist, wobei die zumindest eine Energieversorgungseinheit eingerichtet ist, die zumindest zwei RF-Sendeverstärkerelemente zu betreiben und wobei das Speicherelement Betriebsgrößen-Parameter-Sets für die zumindest eine Energieversorgungseinheit und die zumindest zwei Linearisierungselemente aufweist.
Gemäß einer weiteren bevorzugten Ausgestaltung der vorliegenden Erfindung mag das RF-Sendeverstärkerelement ausgebildet sein als ein Element aus der Gruppe bestehend aus Wanderfeldröhre und Halbleiterverstärker.

Hierdurch mögen sich eine Mehrzahl, exemplarisch 2, 3, bis zu n RF-Sendeverstärkerelemente und zugehörige Linearisierungselemente an eine Energieversorgungseinheit zur Realisierung individueller Arbeitspunkte anschließen.

Gemäß einer weiteren bevorzugten Ausgestaltung der vorliegenden Erfindung mag das Steuersignal von außerhalb einer Plattform empfangbar sein, insbesondere von der Erdoberfläche ausgehend, zum Beispiel im Falle, dass die erfindungsgemäße Steuervorrichtung für eine Wanderfeldröhre auf einer erdfernen Plattform, insbesondere einem Satelliten, vorgesehen ist.

Nachfolgend wird anhand der beigefügten Zeichnungen näher auf Ausführungsbeispiele der Erfindung eingegangen. Es zeigen:
- **Fig. 1**: eine exemplarische Ausgestaltung eines Blockschaltbildes einer einstellbaren Stromversorgung für eine Wanderfeldröhre gemäß der vorliegenden Erfindung;
- **Fig. 2**: eine exemplarische Ausgestaltung eines weiteren Blockschaltbildes einer einstellbaren Stromversorgung für eine Wanderfeldröhre gemäß der vorliegenden Erfindung mit einem Kanalverstärker/Linearisierer;
- **Fig. 3**: eine exemplarische Gegenüberstellung von Hochfrequenzausgangsleistung und Leistungsaufnahme für verschiedene Arbeitspunkte einer Wanderfeldröhre gemäß der vorliegenden Erfindung; und
- **Fig. 4**: eine exemplarische Ausgestaltung eines Verfahrens zum Einstellen eines Arbeitspunktes einer Wanderfeldröhre gemäß der vorliegenden Erfindung.

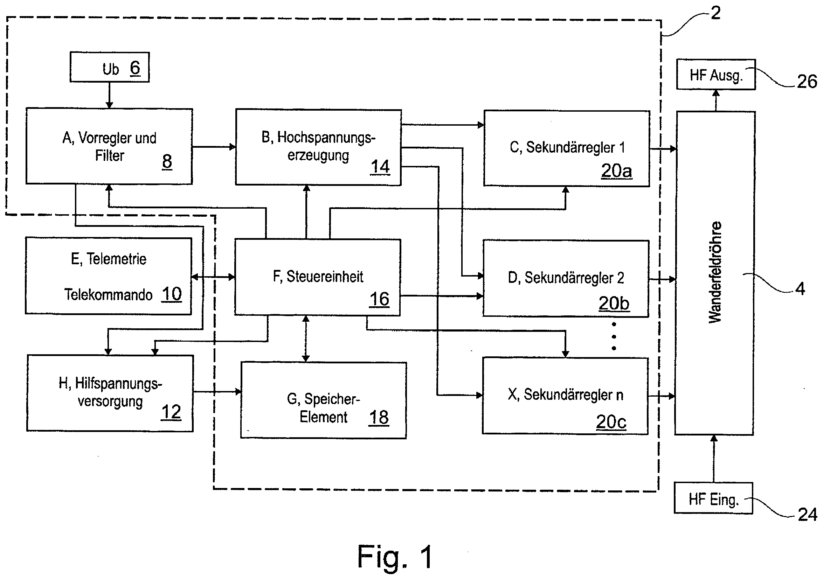

Bezug nehmend auf Figur 1 wird eine exemplarische Ausgestaltung eines Blockschaltbildes einer einstellbaren Stromversorgung für eine Wanderfeldröhre gemäß der vorliegenden Erfindung dargestellt.

Die Steuervorrichtung 2 für die Wanderfeldröhre 4 weist Steuerelement 16 auf, welche eingerichtet ist, von einer Telemetrie bzw. Telekommandoeinheit 10 Informationen bezüglich eines gewünschten Arbeitspunktes der Wanderfeldröhre 4 zu erhalten. Steuerungseinheit 16 ist dabei an Speicherelement 18 angebunden, in welchem Betriebsenergiegrößen-Parameter-Sets, zumindest eines, vorgehalten werden, die Informationen bereitstellen, wie einzelne Elemente, z.B. Elemente 8, 12, 14 und/oder 20a,b,c, einer Energieversorgungseinheit der Steuervorrichtung 2 einzustellen sind. Wanderfeldröhre 4 ist dabei exemplarisch für ein RF-Sendeverstärkungselement.

Unter einstellen wird dabei verstanden, basierend auf dem Betriebsenergiegrößen-Parameter-Set zumindest ein Element von einen Vorregler bzw. Filter 8, einer Hochspannungserzeugung 14, einer Hilfsspannungsversorgung 12 sowie einem oder mehreren Sekundärreglern 20a,b,c derart zu beeinflussen, so dass diese jeweils geforderte Betriebsenergiegrößen bereitstellen, mit denen die Wanderfeldröhre 4 beaufschlagt und damit betrieben werden kann. Dabei müssen nicht sämtliche Betriebsenergiegrößen unmittelbar der Wanderfeldröhre 4 zur Verfügung gestellt werden, beispielsweise kann eine Hochspannungserzeugung 14 ihrerseits ihre Betriebsenergiegröße einem anderen Element, wie exemplarisch den drei Sekundärreglern 20a,b,c, zur Verfügung stellen, welche wiederum ihre Eingangsgrößen aus Hochspannungserzeugung 14 sowie Steuereinheit 16 verwenden, um geeignete Betriebsenergiegrößen an die Wanderfeldröhre 4 weiterzugeben.

So wird der Verstärker über Spannungseingang 6 Ub vom Satelliten mit Spannung versorgt. Über die Filter- und/oder Vorreglerelement 8 wird diese Spannung dem Hochspannungserzeugungselement 14 zugeführt, welches seinerseits verschiedene Versorgungsspannungen für die Wanderfeldröhre 4 erzeugt. Diese Versorgungsspannungen können, wie exemplarisch in Figur 1 dargestellt, unter Verwendung weiterer Sekundärreglerelemente 20a,b,c weiterverarbeitet und beeinflusst werden und erst nachfolgend an die Wanderfeldröhre 4 weitergegeben werden.

Telemetrie-/Telekommandoelement 10 verbindet zum Beispiel eine Kontrollstation am Boden mit dem Satelliten. Die Bodenstation kann dabei Steuerungskommandos an den Satelliten, insbesondere an den Verstärker weitergeben, im Gegenzug mag der Satellit Informationen bezüglich seines Betriebszustandes an die Bodenstation weitergeben. Steuereinheit 16 regelt und kontrolliert im Wesentlichen sämtliche Vorgänge in der Steuervorrichtung.

Die Sollwerte für sämtliche Versorgungsspannungen, welche gleichfalls einen Arbeitspunkt der Steuervorrichtung in einem bestimmten Arbeitspunkt darstellen, zum Beispiel in Bezug auf ein Frequenzband der Wanderfeldröhre 4, können in dem nichtflüchtigen Speicherelement 18 abgelegt sein. Dort mögen auch mehrere Datensätze gespeichert sein, welche beispielsweise bei Bodentests im Rahmen der Herstellung und Vorbereitung der Inbetriebnahme des Satelliten definiert und getestet wurden.

Über die Telemetrie- und Kommandoschnittstelle 10 lassen sich diese verschiedenen Datensätze abrufen und dadurch die Wanderfeldröhre 4 in unterschiedlichen Arbeitspunkten betreiben, je nachdem, in welchem Frequenzbereich der Verstärker betrieben bzw. eine Datenübertragung vorgenommen werden soll. Somit mögen vorteilhaft insbesondere ausschließlich Arbeitspunkte eingestellt werden können, die vorher getestet und in ihrer Korrektheit verifiziert wurden.
Beim Einstellen des Verstärkers auf einen gewünschten Frequenzbereich wird somit der entsprechende Datenblock, somit ein Betriebsenergiegrößen-Parameter-Set, aus dem Speicherelement 18 abgerufen und im Weiteren als ein Betriebsenergiegrößen-Set eingestellt.

Eine derartige Einstellung kann auf verschiedene Weise realisiert werden. So kann der Sollwert für das Vorregler/Filterelement 8 eingestellt werden, wodurch sich die Eingangsspannung für das Hochspannungserzeugungselement 14 und somit eine oder mehrere Versorgungsspannung(en) ändert. Auch oder alternativ können die Sollwerte für die Hochspannungserzeugung 14 selbst eingestellt werden. Hierdurch ändert sich eine bis zu alle Hochspannung(en), welche im Weiteren an die Sekundärregler 20a,b,c oder auch direkt an eine Wanderfeldröhre 4 weitergegeben werden. Zusätzlich zur Hochspannungserzeugung 14 können auch die Sekundärregler 20a,b,c eingestellt werden. Alternativ können auch nur die Sollwerte für die Sekundärregler 20a,b,c eingestellt werden, wodurch sich 1 bis n diskrete Spannungen einstellen und an eine Wanderfeldröhre 4 weitergeben lassen. Der Hochfrequenzeingang 24 und der Hochfrequenzausgang 26 für den Übertragungskanal ist gemäß Figur 1 direkt an die Wanderfeldröhre 4 angebunden, beispielsweise über Zu- und Ableitung einer Helix der Wanderfeldröhre 4.

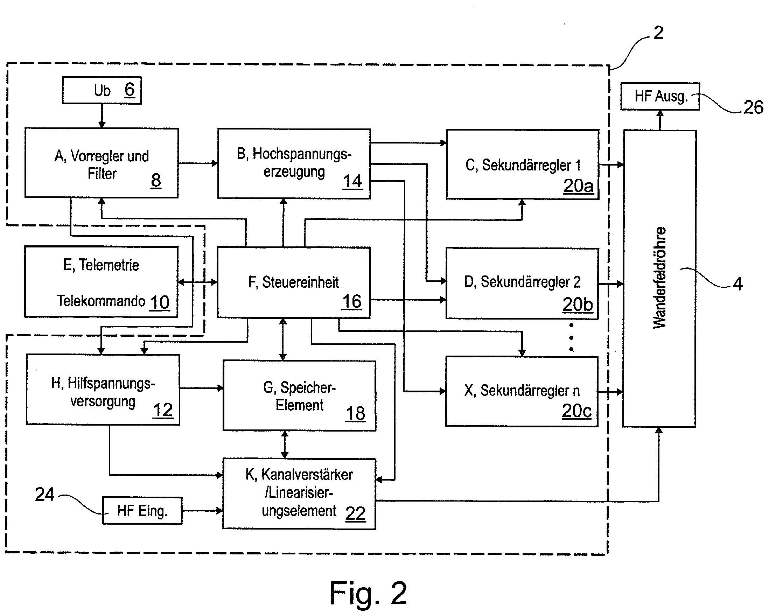

Figur 1 und im weiteren Figur 2 beschreiben eine Ausgestaltung einer Kombination von Speicherelement und Energieversorgungselement. Die Darstellung als individuelle Blöcke A bis H, K und X verdeutlichen jedoch die funktionale Eigenständigkeit der Elemente und die damit verbundene flexible Kombinationsmöglichkeit einzelner Elemente zu komplexeren Gruppen.

Weiter Bezug nehmend auf Figur 2 wird eine weitere exemplarische Ausgestaltung eines Blockschaltbildes einer einstellbaren Stromversorgung für eine Wanderfeldröhre gemäß der vorliegenden Erfindung mit einem Kanalverstärker/Linearisierer dargestellt.

Figur 2 entspricht dabei im Wesentlichen der Figur 1, wobei zusätzlich ein Kanalverstärker/Linearisierungselement 22 vorgesehen ist, welcher einen Hochfrequenzeingang 24 aufweist. Ein Ausgang des Kanalverstärkers/Linearisierers 22 ist mit dem Eingang der Wanderfeldröhre 4 verbunden. Figur 2 stellt dabei im Wesentlichen durch das zusätzliche Vorsehen des Kanalverstärkers/Linearisierers 22 ein Microwave Power Module, ggü. einem TWTA der Figur1, dar.

Handelt es sich, gemäß Figur 2, um eine Microwave Power Module, so kann auch der Kanalverstärker/Linearisierer 22 von der Steuerung passend zu einem geforderten Arbeitspunkt/Frequenzband und/oder Modulationsverfahren der Datenübertragung eingestellt werden. Dabei können die Steuerungsinformationen sowohl intern, falls der Kanalverstärker/Linearisierer 22 integral mit der Steuervorrichtung 2 verbunden ist, oder extern über z.B. einen Kabelbaum, im Falle einer diskreten Realisierung, weitergegeben werden. Der Kanalverstärker/Linearisierer 22 stellt dabei eine Signalvorverarbeitung des Hochfrequenzsignals bereit. Diese Signalvorverarbeitung bzw. die Beeinflussung der Übertragungscharakteristik des Linearisierungselementes 22 kann dabei gleichfalls auf einen bestimmten Arbeitspunkt angepasst sein. Auch eine Anpassung des Kanalverstärkers/Linearisierers 22 bezüglich eines gewünschten Modulationsverfahrens bei gleichbleibendem Frequenzband ist realisierbar.

Generell ist zu erwähnen, dass neben den bereits genannten Einstellungen einer Steuervorrichtung 2 oder einer EPC für eine Wanderfeldröhre 4 das Steuerelement 16 auch das Einstellen von verschiedenen Parametern im Vorverstärker ermöglicht. Dazu können regelmäßig Sollwerte für verschiedene Strom- und/oder Spannungsquellen derart verändert werden, dass eine gewünschte bzw. geforderte Charakteristik des Vorverstärkers eingestellt wird. Diese Einstellungen können blockweise abgespeichert werden, wobei pro Datensatz der Steuervorrichtung in der Regel ein passender Datensatz der Vorverstärkereinstellung abgespeichert wird. Dieser kann im Speicherelement 18 abgelegt sein. Es ist jedoch auch möglich, pro Steuervorrichtungs-Datensatz mehrere Vorverstärker-Datensätze abzuspeichern, wenn zum Beispiel der Kanal auf verschiedene Modulationsverfahren optimiert werden soll.

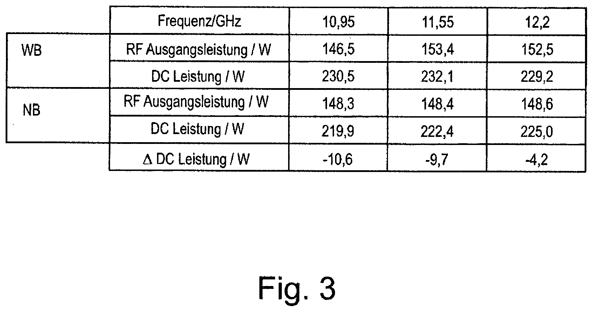

Weiter Bezug nehmend auf Figur 3 wird eine exemplarische Gegenüberstellung von Hochfrequenzausgangsleistung und Leistungsaufnahme für verschiedene Arbeitspunkte einer Wanderfeldröhre gemäß der vorliegenden Erfindung dargestellt.

Figur 3 zeigt exemplarisch Hochfrequenzausgangsleistung und Leistungsaufnahme für verschiedene Betriebsarbeitspunkte eines Verstärkers mit einer Steuervorrichtung gemäß der vorliegenden Erfindung. Exemplarisch handelt es sich hierbei um einen Ku-Band-Verstärker im Bereich von 10.95 - 12.2 GHz. Die Daten zu WB (Wide Band) wurden mit einem Arbeitspunkt aufgenommen, der den gesamten Frequenzbereich bereitstellt. Die zu NB (Narrow Band) aufgeführten Daten wurden in einem auf den jeweiligen Frequenzbereich optimierten Arbeitspunkt gemessen. Zu erkennen ist eine mögliche Einsparung in der Leistungsaufnahme von bis zu 10 W.

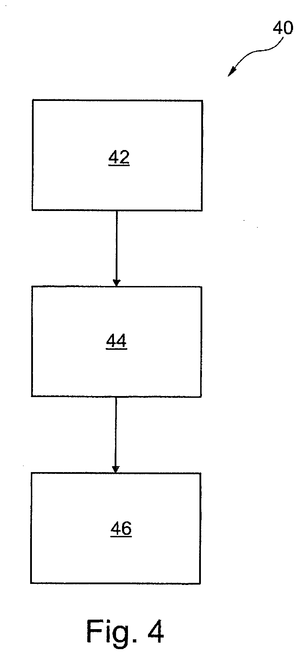

Weiter Bezug nehmend auf Figur 4 wird eine exemplarische Ausgestaltung eines Verfahrens zum Einstellen eines Arbeitspunktes einer Wanderfeldröhre gemäß der vorliegenden Erfindung dargestellt.

Figur 4 zeigt ein Verfahren 40 zum Einstellen eines Arbeitspunktes einer Wanderfeldröhre 4, insbesondere auf einer erdfernen Plattform, aufweisend Erhalten 42 eines Steuersignals, Auswahl 44 eines Betriebsenergiegrößen-Parameter-Sets aus einer Mehrzahl von Betriebsenergiegrößen-Parameter-Sets, welche lokal in einem Speicherelement 18 vorgehalten werden, und Einstellen 46 eines Arbeitspunktes einer Wanderfeldröhre 4, basierend auf dem ausgewählten Betriebsenergiegrößen-Parameter-Set.

Ergänzend sei darauf hingewiesen, dass "aufweisend" bzw." umfassend" keine anderen Elemente oder Schritte ausschließen und dass "eine" bzw. "ein" keine Vielzahl ausschließen. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiel verwendet werden können. Bezugszeichen in den Ansprüchen sind nicht als Einschränkungen anzusehen.

### Bezugszeichenliste

- 2: Steuervorrichtung
- 4: RF-Sendeverstärkerelement
- 6: Versorgungsspannung
- 8: Vorregler/Filter
- 10: Telemetrie-/Telekommandoelement
- 12: Hilfsspannungsversorgung
- 14: Hochspannungserzeugung
- 16: Steuereinheit
- 18: Speicherelement
- 20a,b,c: Sekundärregler
- 22: Kanalverstärker/Linearisierungselement
- 24: Hochfrequenzeingang
- 26: Hochfrequenzausgang

## Patentansprüche

1. Steuervorrichtung (2) für eine erdferne Plattform, aufweisend
eine Steuereinheit (16) mit zumindest einem Steuereingang und einem Steuerausgang; und
ein Speicherelement (18);
wobei das Speicherelement (18) eingerichtet ist, eine Mehrzahl von Betriebsgrößen-Parameter-Sets für zumindest ein RF-Sendeverstärkerelement (4) vorzuhalten;
wobei der Steuereingang eingerichtet ist zum Empfang eines Steuersignals;
wobei die Steuereinheit (16) eingerichtet ist, basierend auf dem Steuersignal ein Betriebsgrößen-Parameter-Set aus dem Speicherelement (18) auszuwählen; und
wobei der Steuerausgang eingerichtet unter Verwendung des ausgewählten Betriebsgrößen-Parameter-Sets eine Energieversorgungseinheit und/oder ein Vorverstärker/Linearisierungselement (22) derart zu beeinflussen, so dass das RF-Sendeverstärkerelement (4) in einem bestimmten Arbeitspunkt betreibbar ist;
wobei das Steuersignal die Information beinhaltet, auf welcher Frequenz bzw. in welchem Frequenzband das RF-Senderverstärkerelement betrieben werden soll.

2. Vorrichtung gemäß Anspruch 1, weiterhin aufweisend
zumindest ein Element aus der Gruppe bestehend aus Energieversorgungseinheit und Vorverstärker/Linearisierungselement (22);
wobei die Energieversorgungseinheit zur Bereitstellung einer Mehrzahl von Betriebsgrößen an das RF-Sendeverstärkerelement (4), definierend ein Betriebsgrößen-Set, eingerichtet ist;
wobei das Betriebsgrößen-Set einen Arbeitspunkt des RF-Sendeverstärkerelement (4) bestimmt;
wobei durch eine Mehrzahl von Betriebsgrößen-Sets eine Mehrzahl von Arbeitspunkten bestimmbar ist;
wobei das Vorverstärker/Linearisierungselement (22) einem HF-Eingang (24) und einem HF-Ausgang zum Anschluss an ein RF-Sendeverstärkerelement (4) aufweist und eingerichtet ist, ein HF-Signal über den HF-Eingang (24) aufzunehmen und unter Berücksichtigung eines Arbeitspunktes des RF-Sendeverstärkerelementes (4) vorzuverarbeiten; und
wobei die Vorverarbeitung bzw. Übertragungscharakteristik des Linearisierungselementes (22) basierend auf einem bestimmten Arbeitspunkt einstellbar ist; insbesondere wobei das Betriebsgrößen-Parameter-Set zumindest einen Parameter zur Einstellung des Linearisierungselementes (22) aufweist, zur Anpassung der Vorverarbeitung des HF-Signals auf einem bestimmten Arbeitspunkt des RF-Sendeverstärkerelementes (4).

3. Vorrichtung gemäß Anspruch 2, wobei das RF-Sendeverstärkerelement (4) durch Einstellen bzw. Ausgeben eines Betriebsgrößen-Sets der Energieversorgungseinheit an das RF-Sendeverstärkerelement (4) einen bestimmten Arbeitspunkt einnimmt.

4. Vorrichtung gemäß einem der vorhergehenden Ansprüche, wobei die Betriebsgrößen ausgebildet sind als Größen aus der Gruppe bestehend aus Strömen bzw. Spannungen, die an ein RF-Sendeverstärkerelement (4) anlegbar bzw. weitergebbar sind, eine Helix-Spannung, eine Kollektor-Spannung, ein Kathodenstrom, eine Anoden-0-Spannung, eine Anoden-1-Spannung, eine Heizerspannung, eine Wehneltspannung, eine Amplitudenexpansion, eine Phasendrehung, ein Frequenzgang und eine Verstärkung.

5. Vorrichtung gemäß einem der vorhergehenden Ansprüche, wobei der Arbeitspunkt zumindest den Frequenz-Arbeitsbereich des RF-Sendeverstärkerelementes (4) beeinflusst bzw. bestimmt.

6. Vorrichtung gemäß einem der vorhergehenden Ansprüche, wobei die Vorrichtung eingerichtet ist, mittels der Mehrzahl der Betriebsgrößen-Parameter-Sets weiterhin an ein gefordertes Modulationsverfahren für eine Datenübertragung anpassbar zu sein.

7. Vorrichtung gemäß einem der vorhergehenden Ansprüche, wobei das Speicherelement in der Steuereinheit, in der Energieversorgungseinheit oder in dem Vorverstärker/Linearisierer angeordnet ist oder als verteiltes Speicherelement ausgebildet ist und in einer Mehrzahl von Steuereinheit, Energieversorgungseinheit und Vorverstärker/Linearisierungselement (22) angeordnet ist.

8. Vorrichtung gemäß einem der Ansprüche 2 bis 7, aufweisend
zumindest zwei RF-Sendeverstärkerelemente (4);
zumindest zwei Linearisierungselemente (22); und
zumindest eine Energieversorgungseinheit;
wobei ein RF-Sendeverstärkerelement (4) jeweils einem Vorverstärker/Linearisierungselement (22) zugeordnet ist;
wobei die zumindest eine Energieversorgungseinheit eingerichtet ist, die zumindest zwei RF-Sendeverstärkerelemente (4) zu betreiben; und
wobei das Speicherelement (18) Betriebsgrößen-Parameter-Sets für die zumindest eine Energieversorgungseinheit und die zumindest zwei Linearisierungselemente (22) aufweist.

9. Vorrichtung gemäß einem der vorhergehenden Ansprüche, wobei das RF-Sendeverstärkerelement (4) ausgebildet ist als ein Element aus der Gruppe bestehend aus Wanderfeldröhre und Halbleiterverstärker.

10. Erdferne Plattform, insbesondere Satellit, aufweisend eine Vorrichtung (2) gemäß einem der vorhergehenden Ansprüche.

11. Plattform gemäß Anspruch 10, wobei das Steuersignal von außerhalb der Plattform empfangbar ist, insbesondere von der Erdoberfläche ausgehend.

12. Verfahren (40) zum Einstellen eines Arbeitspunktes eines RF-Sendeverstärkerelementes (4) auf einer erdfernen Plattform, aufweisend
Erhalten (42) eines Steuersignals;
Auswahl (44) eines Betriebsgrößen-Parameter-Sets aus einer Mehrzahl von Betriebsgrößen-Parameter-Sets, welche lokal in einem Speicherelement (18) vorgehalten werden; und
Einstellen (46) eines Arbeitspunktes eines RF-Sendeverstärkerelementes (4) basierend auf dem ausgewählten Betriebsgrößen-Parameter-Set;
wobei das Steuersignal die Information beinhaltet, auf welcher Frequenz bzw. in welchem Frequenzband das RF-Senderverstärkerelement betrieben werden soll.

## Claims

1. Control apparatus (2) for an Earth-remote platform, having
a control unit (16) having at least one control input and a control output; and
a memory element (18);
wherein the memory element (18) is configured to hold a plurality of operating variable parameter sets for at least one RF transmission amplifier element (4); wherein the control input is configured to receive a control signal;
wherein the control unit (16) is configured to take the control signal as a basis for selecting an operating variable parameter set from the memory element (18); and
wherein the control output is configured to use the selected operating variable parameter set to influence a power supply unit and/or a preamplifier/linearization element (22) such that the RF transmission amplifier element (4) is operable at a determined operating point;
wherein the control signal contains the information concerning the frequency or frequency band on or in which the RF transmission amplifier element is supposed to be operated.

2. Apparatus according to Claim 1, additionally having
at least one element from the group consisting of power supply unit and preamplifier/linearization element (22);
wherein the power supply unit is configured to provide a plurality of operating variables to the RF transmission amplifier element (4), defining an operating variable set;
wherein the operating variable set determines an operating point for the RF transmission amplifier element (4);
wherein a plurality of operating points are determinable by a plurality of operating variable sets; wherein the preamplifier/linearization element (22) has an RF input (34) and an RF output for connection to an RF transmission amplifier element (4) and is configured to pick up an RF signal via the RF input (24) and to preprocess said RF signal by taking into consideration an operating point of the RF transmission amplifier element (4); and
wherein the preprocessing or the transfer characteristic of the linearization element (22) is adjustable on the basis of a determined operating point; in particular wherein the operating variable parameter set has at least one parameter for adjusting the linearization element (22), to match the preprocessing of the RF signal to a determined operating point of the RF transmission amplifier element (4).

3. Apparatus according to Claim 2, wherein the RF transmission amplifier element (4) adopts a determined operating point as a result of an operating variable set of the power supply unit being engaged or output to the RF transmission amplifier element (4).

4. Apparatus according to one of the preceding claims, wherein the operating variables are in the form of variables from the group consisting of currents or voltages applicable or forwardable to an RF transmission amplifier element (4), a helix voltage, a collector voltage, a cathode current, an anode 0 voltage, an anode 1 voltage, a filament voltage, a Wehnelt voltage, an amplitude expansion, a phase rotation, a frequency response and a gain.

5. Apparatus according to one of the preceding claims, wherein the operating point influences or determines at least the frequency operating range of the RF transmission amplifier element (4).

6. Apparatus according to one of the preceding claims, wherein the apparatus is configured to continue to be matchable to a required modulation method for a data transmission by means of the plurality of operating variable parameter sets.

7. Apparatus according to one of the preceding claims, wherein the memory element is arranged in the control unit, in the power supply unit or in the preamplifier/linearizer or is in the form of a distributed memory element and is arranged in a plurality of control units, power supply units and preamplifier/linearization elements (22).

8. Apparatus according to one of Claims 2 to 7, having
at least two RF transmission amplifier elements (4);
at least two linearization elements (22); and
at least one power supply unit;
wherein an RF transmission amplifier element (4) is associated with a respective preamplifier/linearization element (22);
wherein the at least one power supply unit is configured to operate the at least two RF transmission amplifier elements (4); and
wherein the memory element (18) has operating variable parameter sets for the at least one power supply unit and the at least two linearization elements (22).

9. Apparatus according to one of the preceding claims, wherein the RF transmission amplifier element (4) is in the form of an element from the group consisting of travelling wave tube and semiconductor amplifier.

10. Earth-remote platform, in particular satellite, having an apparatus (2) according to one of the preceding claims.

11. Platform according to claim 10, wherein the control signal is receivable from outside the platform, in particular from Earth's surface.

12. Method (40) for setting an operating point for an RF transmission amplifier element (4) on an Earth-remote platform, involving
receiving (42) a control signal;
selecting (44) an operating variable parameter set from a plurality of operating variable parameter sets held locally in a memory element (18); and
setting (46) an operating point for an RF transmission amplifier element (4) on the basis of the selected operating variable parameter set;
wherein the control signal contains the information concerning the frequency or frequency band on or in which the RF transmission amplifier element is supposed to be operated.

## Revendications

1. Dispositif de commande (2) pour une plateforme à l'apogée, comprenant
une unité de commande (16) dotée d'au moins une entrée de commande et d'une sortie de commande ; et
un élément de mémorisation (18) ;
l'élément de mémorisation (18) étant conçu pour stocker une pluralité de paramètres de grandeurs opérationnelles pour au moins un élément amplificateur d'émission RF (4) ; l'entrée de commande étant conçue pour recevoir un signal de commande ;
l'unité de commande (16) étant conçue pour sélectionner un jeu de paramètres de grandeurs opérationnelles dans l'élément de mémorisation (18) en se basant sur le signal de commande ; et
la sortie de commande étant conçue pour, en utilisant le jeu de paramètres de grandeurs opérationnelles sélectionné, influencer une unité d'alimentation en énergie et/ou un préamplificateur / élément de linéarisation (22) de telle sorte que l'élément amplificateur d'émission RF (4) peut fonctionner dans un point de fonctionnement donné ;
le signal de commande contenant l'information de la fréquence sur laquelle ou de la bande de fréquences dans laquelle doit fonctionner l'élément amplificateur d'émission RF.

2. Dispositif selon la revendication 1, comprenant en outre
au moins un élément du groupe composé de l'unité d'alimentation en énergie et du préamplificateur / élément de linéarisation (22) ;
l'unité d'alimentation en énergie étant conçue pour fournir à l'élément amplificateur d'émission RF (4) un jeu de grandeurs opérationnelles qui définit une pluralité de grandeurs opérationnelles ;
le jeu de grandeurs opérationnelles déterminant un point de fonctionnement de l'élément amplificateur d'émission RF (4) ;
une pluralité de points de fonctionnement pouvant être définis par une pluralité de jeux de grandeurs opérationnelles ;
le préamplificateur / élément de linéarisation (22) possédant une entrée HF (24) et une sortie HF destinée au raccordement à un élément amplificateur d'émission RF (4) et étant conçu pour recevoir un signal HF par le biais de l'entrée HF (24) et le prétraiter en tenant compte d'un point de fonctionnement de l'élément amplificateur d'émission RF (4) ; et
le prétraitement ou la caractéristique de transmission de l'élément de linéarisation (22) étant réglable sur la base d'un point de fonctionnement déterminé ; le jeu de paramètres de grandeurs opérationnelles possédant au moins un paramètre servant au réglage de l'élément de linéarisation (22) en vue d'adapter le prétraitement du signal HF à un point de fonctionnement déterminé de l'élément amplificateur d'émission RF (4).

3. Dispositif selon la revendication 2, l'élément amplificateur d'émission RF (4) adoptant un point de fonctionnement déterminé par réglage ou délivrance du jeu de grandeurs opérationnelles de l'unité d'alimentation en énergie à l'élément amplificateur d'émission RF (4).

4. Dispositif selon l'une des revendications précédentes, les grandeurs opérationnelles étant réalisées sous la forme de grandeurs issues du groupe composé de courants ou de tensions qui peuvent être appliqués ou peuvent être retransmis à un élément amplificateur d'émission RF (4), une tension d'hélice, une tension de collecteur, un courant de cathode, une tension d'anode 0, une tension d'anode 1, une tension d'élément chauffant, une tension de Wehnelt, une expansion de l'amplitude, une rotation de phase, une réponse fréquentielle et un gain.

5. Dispositif selon l'une des revendications précédentes, le point de fonctionnement influençant ou déterminant au moins la plage de fonctionnement de fréquences de l'élément amplificateur d'émission RF (4).

6. Dispositif selon l'une des revendications précédentes, le dispositif étant conçu pour pouvoir, au moyen d'une pluralité de jeux de paramètres de grandeurs opérationnelles, être en plus adapté à un procédé de modulation exigé pour une transmission de données.

7. Dispositif selon l'une des revendications précédentes, l'élément de mémorisation étant disposé dans l'unité de commande, dans l'unité d'alimentation en énergie ou dans le préamplificateur / élément de linéarisation ou étant réalisé sous la forme d'un élément de mémorisation divisé et disposé dans une pluralité parmi l'unité de commande, l'unité d'alimentation en énergie et le préamplificateur / élément de linéarisation (22).

8. Dispositif selon l'une des revendications 2 à 7, comprenant
au moins deux éléments amplificateurs d'émission RF (4) ;
au moins deux éléments de linéarisation (22) ; et
au moins une unité d'alimentation en énergie ;
un élément amplificateur d'émission RF (4) étant respectivement associé à un préamplificateur / élément de linéarisation (22) ;
l'au moins une unité d'alimentation en énergie étant conçue pour faire fonctionner les au moins deux éléments amplificateurs d'émission RF (4) ; et
l'élément de mémorisation (18) possédant des jeux de paramètres de grandeurs opérationnelles pour l'au moins une unité d'alimentation en énergie et les au moins deux éléments de linéarisation (22).

9. Dispositif selon l'une des revendications précédentes, l'élément amplificateur d'émission RF (4) étant réalisé sous la forme d'un élément du groupe composé de tubes à champ d'ondes progressives et d'amplificateurs à semiconducteur.

10. Plateforme à l'apogée, notamment satellite, comprenant un dispositif (2) selon l'une des revendications précédentes.

11. Plateforme selon la revendication 10, le signal de commande pouvant être reçu depuis en-dehors de la plateforme, notamment depuis la surface de la Terre.

12. Procédé (40) de réglage d'un point de fonctionnement d'un élément amplificateur d'émission RF (4) sur une plateforme à l'apogée, comprenant
obtention (42) d'un signal de commande ;
sélection (44) d'un jeu de paramètres de grandeurs opérationnelles parmi une pluralité de jeux de paramètres de grandeurs opérationnelles qui sont stockés localement dans un élément de mémorisation (18) ; et
réglage (46) d'un point de fonctionnement d'un élément amplificateur d'émission RF (4) sur la base du jeu de paramètres de grandeurs opérationnelles sélectionné ;
le signal de commande contenant l'information de la fréquence sur laquelle ou de la bande de fréquences dans laquelle doit fonctionner l'élément amplificateur d'émission RF.
